# EUROPEAN PATENT APPLICATION

(11) **EP 1 011 135 A2**
(43) Date of publication of application: **21.06.2000**
(21) Application number: 99204265.5
(22) Date of filing: 13.12.1999
(51) Int. Cl.: H01L 21/768, H01L 21/027

(54) **Semiconductor interconnect structure employing a pecvd inorganic dielectric layer and process for making same**

(30) Priority: 14.12.1998 US 210965
(71) Applicant: Conexant Systems, Inc., Newport Beach, California 92660-3095 (US)
(72) Inventor: Hsia, Shao-Wen, Mission Viejo, California 92692 (US); Brongo, Maureen R., Laguna Hills, California 92653 (US)
(74) Representative: Hanna, Peter William Derek

(57) **Abstract**

An inorganic dielectric anti-reflective coating (ARC) layer used in semiconductor interconnect structures for facilitating the use of thin photoresist layers while preserving the integrity of the photoresist pattern (304, 306, 308) for deep sub-micron feature sizes. The inorganic dielectric ARC layer also functions as a hard mask during metal etching thereby further enhancing the integrity of metallic microelectronic structures.

## Description

### BACKGROUND OF THE INVENTION

### 1. Technical Field

The present invention relates, generally, to thin film anti-reflective coatings (ARC) used in semiconductor interconnect structures and, more particularly, to an inorganic dielectric ARC which also functions as a hard mask.

### 2. Background Art and Technical Problems

Recent advances in semiconductor processing technology have led to the development of integrated circuit devices employing sub-micron and even deep sub-half-micron feature sizes. Deep sub-micron technologies, involving critical dimensions or feature sizes of less than 0.35 microns, require photo lithographic processes which employ progressively smaller incident wavelengths during the exposure process.

In addition, deep sub-micron feature sizes have spawned the development of sophisticated new photoresist recipes for use with these smaller wavelengths.

Deep sub-micron line widths also tend to drive a reduction in the thickness of the photoresist layers in order to maintain acceptable aspect ratios for the photoresist patterns. However, the use of thinner photoresist pattern layers has resulted in undesired erosion of the patterned microelectronic structure during the metal etch process.

Presently known attempts to preserve the integrity of the microelectronic structures in the presence of thin photoresist layers typically involve the use of a silicon dioxide layer on top of the metal stack. In addition, organic anti-reflection coating (ARC) layers have been employed on top of silicon dioxide layers to help preserve the structural integrity of the photoresist pattern structures. However, these organic ARC and silicon layers require different etching chemistries that are not compatible with metal etching. Consequently, there is an increase in processing steps and manufacturing complexity thereby resulting in lower throughput and high cost of the integrated circuit devices.

Composite structures and manufacturing processes are thus needed which accommodate the progression towards smaller exposure wavelengths and thinner photoresist layers, but which do not unnecessarily add to the cost and complexity of the fabrication process.

### SUMMARY OF THE INVENTION

In accordance with a preferred embodiment of the present invention, a metal layer upon which photoresist patterns are developed comprises a sandwiched metal stack having a layer of conducting metal (aluminum, titanium, and the like) bounded by an upper thin-film ARC layer and a bottom thin-film barrier layer, wherein at least the top layer is composed of an inorganic dielectric substance. The use of an inorganic dielectric top ARC layer facilitates use of thinner photoresist layers while preserving the integrity of the photoresist pattern for deep sub-micron feature sizes. In addition, the inorganic ARC layer functions as a hard mask during the metal etch process, further enhancing the integrity of the metallic microelectronic structures even as the photoresist is eroded during the metal etch process.

In accordance with a further aspect of the present invention, the inorganic dielectric layer may be applied utilizing a chemical vapor deposition (CVD) process. In accordance with a particular preferred embodiment, the inorganic dielectric ARC layer may be applied in a plasma enhanced CVD (PECVD) chamber.

In accordance with a further aspect of the present invention, the use of PECVD deposition techniques permits the application of the dielectric layer in a conformal manner, i.e., a uniform thickness of the dielectric may be applied to surfaces which are not perfectly planar, for example surfaces which contain a layer of microelectronic structures. This is a distinct advantage over prior art systems, wherein organic ARC layers are typically applied using a spin coat technique.

In accordance with a further aspect of the present invention, the etch selectivity of the metal etch medium is greatly enhanced in that the inorganic ARC is less susceptible to erosion during the metal etch process than prior art organic or metallic ARC layers.

In accordance with yet a further aspect of the present invention, the inorganic dielectric layer may be incorporated into the interconnect structure, without having to be removed in a subsequent processing step.

In accordance with a still further aspect of the present invention, the process of etching the inorganic dielectric layer down to the metal layer may be performed in the same tool within which the metal etching process is performed, thereby eliminating the need to change tooling between the dielectric etching step and the metal etching step.

In accordance with yet a further aspect of the present invention, the inorganic dielectric ARC layer may be etched using a fluorine based etching solution, immediately followed by the in-situ transition to a chlorine based etching process for the metal etching step.

Various other aspects and advantages of the present invention are set forth with particularity in the detailed description of preferred exemplary embodiments.

### BRIEF DESCRIPTION OF THE DRAWINGS

The present invention will hereinafter be described in conjunction with the appended drawing figures, wherein like numerals designate like elements in the various figures, and wherein:
FIG. 1a is a schematic diagram of a photo lithographic exposure and development process;
FIG. 1b is a schematic diagram of an exemplary printed photoresist pattern using prior art techniques;
FIG. 1c is a schematic illustration of a metallic microelectronic structure after pattern and transfer, shown with compromised structural integrity as a result of a thin photoresist layer;
FIG. 2a is a schematic illustration of reflected incident light on the sidewall profile of photoresist structures;
FIG. 2b is a schematic illustration of prior art photoresist structures showing the vertical walls of the photoresist structures corrupted by the spurious reflected light shown in FIG. 2a;
FIG. 3a is a schematic illustration of a prior art exposure and development paradigm employing an organic anti-reflective coating on the metal layer;
FIG. 3b is schematic illustration of a prior art photoresist pattern transfer technique produced using an organic anti-reflective coating, with the resulting preservation of the structural integrity of the metallic microelectronic structures;
FIG. 4 is a schematic illustration of an inorganic dielectric boundary layer in accordance with the present invention;
FIG. 5 is a schematic illustration of the conformal application of a dielectric boundary layer in accordance with the present invention;
FIG. 6a is a schematic illustration of a printed photoresist pattern using an inorganic dielectric layer in accordance with the present invention;
FIG. 6b is a schematic illustration of a photoresist pattern, showing the inorganic top ARC layer of FIG. 6a removed as a result of etching;
FIG. 6c is a schematic illustration of the resulting microelectronic structures subsequent to the metal etching process in accordance with the present invention;
FIG. 7 is a schematic block diagram of an exemplary plasma etching chamber in accordance with the present inventions and
FIG. 8 is a flow chart setting forth various process steps employed in the context of the present invention.

### DETAILED DESCRIPTION OF THE PREFERRED EXEMPLARY EMBODIMENTS

For relatively large line widths, standard photo lithographic processes typically employ G-line (436 nanometers) or I-line (365 nanometers) exposure wavelengths. However, I-line photo lithographic processes are limited to line width critical dimensions on the order of about .36 micron feature size; thus, for deep sub-half-micron feature sizes, deep ultraviolet exposure energies (e.g., 248 nanometers) or lower energies are needed.

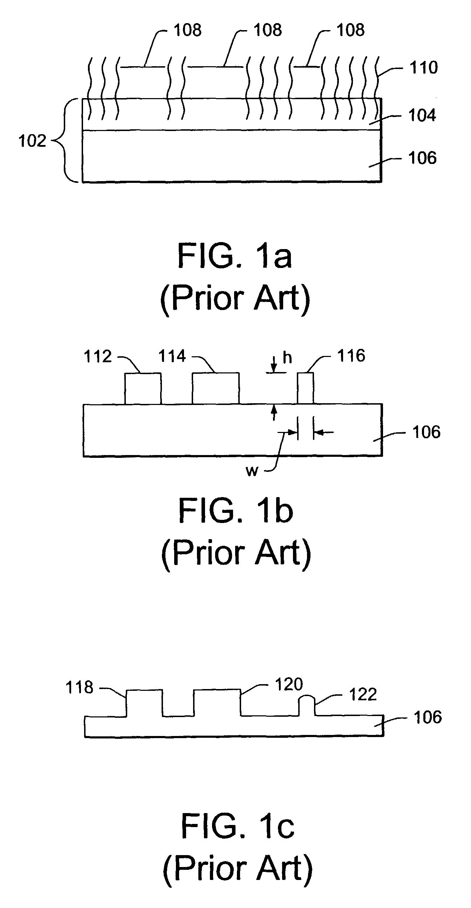

FIG. 1a shows a typical interconnect substrate **102** comprising a metal layer **106** and a photoresist layer **104** disposed on top of the metal layer. As is well known in the art, exposure radiation is selectively applied to a mask or reticle to selectively expose and isolate various regions of the photoresist layer to develop a photoresist pattern. This photoresist pattern is then subsequently transferred into the metal layer.

With continued reference to FIG. 1a, mask **108** patterns the incident light rays **110** in accordance with a predetermined photoresist pattern. Consequently, light is blocked from those areas of the photoresist layer **104** corresponding to a desired printed photoresist pattern, and light is allowed to penetrate into those regions of the photoresist layer **104** which are desired to be removed during the development step. Those skilled in the art will appreciate, however, that a variety of different expose and development paradigms may be employed to arrive at a desired photoresist pattern; for example, it may be desirable to configure the mask such that the areas of the photoresist layer **104** to be removed are blocked from the light, and the areas of the photoresist layer **104** which are desired to be preserved are exposed.

With continued reference to FIG. 1a and now also referring to FIG. 1b, after the regions of photoresist layer **104** which are desired to be removed have been exposed and developed, the photoresist pattern is said to be printed upon metal layer **106**. In the context of FIG. 1b, the printed photoresist pattern comprises respective photoresist structures **112,114,116**.

Referring now to FIG. 1a-c, the photoresist pattern shown in FIG. 1b is typically transferred to metal layer **106** through a metal etching process, wherein the metal **106** and the photoresist structures **112,114,116** are simultaneously etched and removed resulting in the metal microelectronic pattern shown in FIG. 1c comprising respective metal structures **118,120,122.**

As the line widths (represented by the arrows marked "w" in FIG. 1b) of the structures become smaller and smaller (e.g., less than .5 microns in width), the mechanical integrity of the photoresist structures **112,114,116,** as well as the metallic structures **118,120,122** may become compromised. In order to prevent the photoresist and metal structures from becoming too thin or from having an excessively large vertical dimension ratios (represented by the arrows "h" in FIG. 1b) for a given line width, it is desirable to maintain an aspect ratio (h/w) on the order of 2.5 to 4.

With continued reference to FIG. 1c, it can be seen that microelectronic structure **122** exhibits compromised structural integrity; in particular, the top portion of structure **122** deviates from the desired rectilinear configuration. Those skilled in the art will appreciate this type of depth deformation typically results when the photoresist material completely or partially erodes in the metal etch process, leaving the top portion of microelectronic structure **122** exposed to the etching medium. This problem becomes exacerbated in current technologies when thinner photoresist layers are needed in order to accommodate the narrower depth of focus windows associated with deep sub-micron feature sizes.

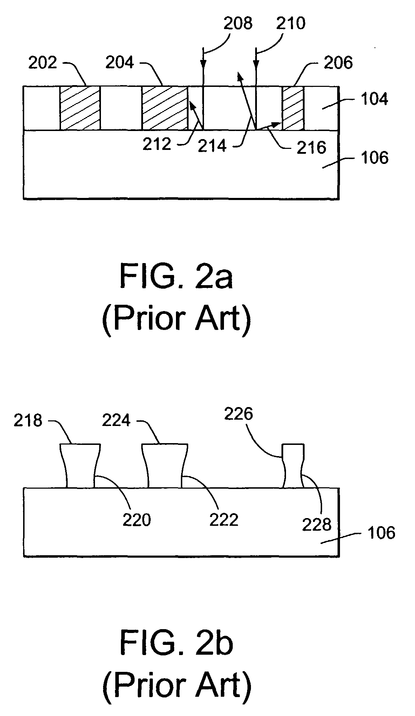

Referring to FIG. 2, presently known interconnect processing paradigms suffer from additional drawbacks beyond the profile erosion discussed in conjunction with FIG. 1. FIG. 2 illustrates a typical microelectronic substrate comprising a metal layer **106** and a photoresist layer **104**. As discussed above, a photoresist pattern comprising photoresist features **202,204,206** is desirably printed on metal layer **106**. Using an appropriate mask (not shown in FIG. 2) of the type discussed above in conjunction with FIG. 1, exposure energy of a predetermined wavelength, represented by light vectors **208,210** are applied to photoresist layer **104** in the vertical direction shown in FIG. 2a. In an ideal environment, these vertical rays create photoresist structures (e.g., structures **202,204,206**) having straight, ideally vertical side walls. However, although the incident light rays **208,210** are generally vertically aligned, when the light waves contact the surface of metal layer **106** which adjoins photoresist layer **104**, the light rays often reflect against the surface of metal layer **106**, resulting in spurious reflection rays, for example reflected rays **212,214,216**. Although photoresist structures **202,204,206** are masked to prevent them from being exposed during the exposure stage, spurious reflected rays (e.g., rays **212,216**) often penetrate the side walls of the photoresist structures, resulting in undesirable exposure of portions of the side walls of the photoresist structures. In particular, spurious ray **212** can be seen contacting the side wall of photoresist structure **204**; similarly, spurious wave **216** can be seen contacting the side wall of photoresist structure **206**.

Referring now to FIG. 2b, the effect of such spurious reflective light rays can be seen in the distorted, non-linear side walls of the developed photoresist structure **218** (corresponding to desired profile **202**), photoresist structure **224** (corresponding to desired profile **204**), and photoresist structure **226** (corresponding to desired profile **206**). In particular, respective side walls **220,222,228** of respective photoresist structures **218,224,226** are partially consumed as a result of the undesired exposure of the side walls.

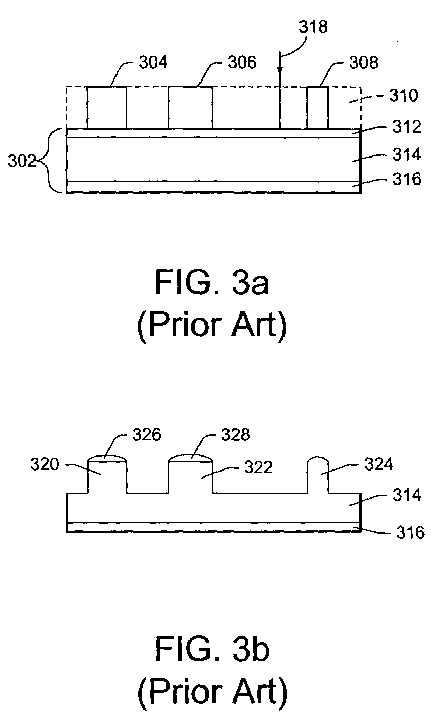

Referring now to FIG. 3, presently known techniques for reducing spurious reflected light rays during photoresist patterning typically involve the use of an ARC layer **312**.

More particularly, prior art processing paradigms often employ a stacked metal layer **302**, for example comprising middle metal layer **314** sandwiched between a top anti-reflective coating (ARC) layer **312**, and a bottom thin film baffler layer **316**.

More particularly and with reference to FIG. 3a, as the vertically incident exposure energy represented by vector **318** enters photoresist layer **310**, a portion of photoresist layer **310** which is desired to be removed is exposed during the exposure step. ARC layer **312**, which typically comprises a material designed to absorb the exposure light, substantially reduces spurious reflected rays during the exposure step. Consequently, only that portion of photoresist layer **310** (represented by the dotted lines) is removed during the developing step, thereby resulting in substantially linear, non-eroded side walls of finished photoresist structures **304,306,308**.

Initial ARC layers, for example such as ARC layer **312**, are made from a metallic material, for example titanium nitride, often referred to as tinitride. Consequently, this metallic ARC layer may be etched in the same chemistry that is used for metal etching. In addition to using metallic ARC layers, organic ARC layers (not shown) have also been used to preserve the structural integrity of the photoresist layer 310 by depositing the organic ARC layer (not shown) on top of the metallic ARC layer. In addition to the ARC layers, silicon dioxide layers have also been employed as hard mask layers to preserve the integrity of the microelectronic structures. However, the use of an organic ARC layer and/or a silicon dioxide hard mask requires different etching chemistries than those used for etching the metallic ARC layer and metal layer, thereby requiring additional etching tools and increased processing times.

Referring now to FIG. 3b, the substrate of FIG. 3a is shown subsequent to the metal etching step. In particular, metal portion **314** is etched using any well known wet or dry etching technique. Photoresist structures **304,306,308** are transferred to the metal layer **314** during the metal etch process. In particular, photoresist structure **304** is transferred into the metal layer as microelectronic structure **320**; photoresist structure **306** is seen transferred into the metal layer as microelectronic structure **322**; and photoresist structure 308 is transferred into the metal layer as microelectronic structure 324. In circumstances where sufficiently thick photoresist layers are employed, or when a less aggressive metal etching medium is used, often the top portion of microelectronic structures **320,322** remain generally rectilinear as a result of residual photoresist **326,328** which was not consumed during the metal etching step. However, the integrity of the microelectronic structure (e.g. Structure **324**) may nonetheless be compromised even in the presence of ARC layer **321** due to, *inter alia*, one or more of the following conditions; an aggressive etching medium which fully or partially consumes the ARC layer, employing a photoresist layer which is too thin and hence is eroded during the metal etch process, and deep sub-micron feature sizes.

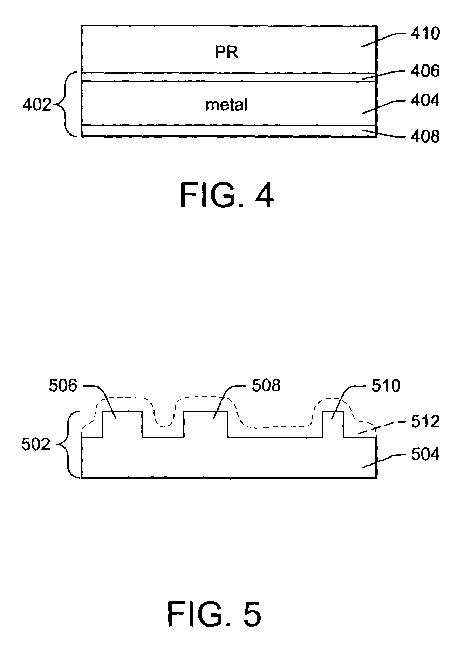

Referring now to FIG 4, a suitable interconnect substrate in accordance with the present invention comprises a metallic stack **402** having a photoresist layer **410** disposed thereon. In accordance with one aspect of the present invention, metallic stack **402** disposed thereon. In accordance with one aspect of the present invention, metallic stack **402** is suitably in the range of 1,000 to 20,000 angstroms thick, and is preferably about 5,000 to 8,000 angstroms; photoresist layer **410** is suitably on the order of .1 to 2 microns thick, and preferably on the order of about .6 to 1.0 microns thick. In accordance with a further aspect of the present invention, metallic stack **402** suitably comprises a metal layer **404** sandwiched between a first top ARC layer **406** and a second bottom barrier layer **408**. Preferably, top ARC layer **406** is a dielectric, inorganic compound, for example silicon oxynitride.

In accordance with one aspect of the present invention, metal layer **404** is suitably made for aluminium, titanium, or other metals typically employed in the production of stacked semiconductor assemblies. If desired, metal layer **404** may also include gold, silver, copper, either alone, in combination, or mixed with the aluminium, titanium, or the like. Moreover, depending on the particular application, metal layer **404** may comprise tungsten, nickel, or other substances, for example if the substrate is to be employed as a memory disk or other structure other than a semiconductor stacked assembly. The thickness of metal 404 may vary from application to application; however the metal layer 404 thickness in accordance to an explicatory embodiment of the invention is about 1,000 to about 20,000 Angstroms.

With continued reference to FIG 4, inorganic dielectric layer **406** is suitably applied to metal layer **404** in any convenient manner. In a particularly preferred embodiment, inorganic layer **406** is applied to layer **404** through chemical vapour deposition (CVD) techniques. In a particularly preferred embodiment, plasma enhanced CVD (PECVED) techniques may be employed to deposit inorganic layer **406** on metal layer **404**. Although dielectric layer **406** thickness may vary from application to application, the dielectric layer **406** thickness is preferably about 50 to 1,000 angstroms.

Referring now to FIG. 5, an alternate embodiment of the invention is shown. In particular, an inorganic layer **512** is shown applied on the surface of metal layer **504**, notwithstanding the non-planar surface of metal layer **504**.

With continued reference to FIG. 5, metal layer **504** suitably comprises respective structures **506, 508, 510**, for example microelectronic structures; instead, structures **506,508, 510**, may also comprise steps, ridges, or other topical non-planarities other than microelectronic structures. By employing CVD or other application techniques other than traditional well-know "spin" techniques, it is possible to apply a substantially uniform thickness of the inorganic layer onto the metal layer, regardless of whether the metal layer is substantially planar or deviates from planarity. FIG. 5, thus illustrates the conformal nature of the inorganic layer to metallic layer.

After applying the inorganic layer to the metal layer as shown in FIG. 4 (or in the alternate embodiment shown in FIG. 5), it may be desirable to apply a photoresist layer **410** to the inorganic layer. In this regard, it is appreciated that the inorganic layer **406** may serve a plurality of useful purposes. In particular, inorganic layer **406** (and inorganic layer **512** in the alternative embodiment) may effectively serve as an ARC layer, thereby enhancing the verticality of the side walls of the photoresist structures by reducing spurious reflected rays during the exposure and developing steps. In addition, as discussed in greater detail below, inorganic layer **406** may enhance the integrity of the structure of the finished microelectronic structures after metal etching, even if the residual photoresist should become partially or fully eroded.

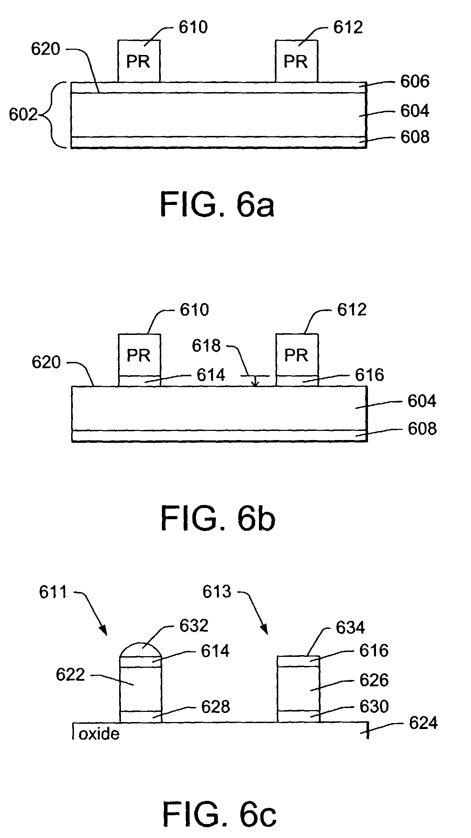

Referring now to FIG. 6, an exemplary metal structure **602** suitably comprises a metal layer **604**, an inorganic top layer **606**, and a bottom barrier layer **608**, which may comprise a dielectric; in a preferred embodiment, bottom barrier layer **608**, is also a metal such a tinitride. In accordance with an exemplary embodiment of the invention layer **608** is less than about 3,000 angstroms thick. As briefly discussed above in conjunction with FIG. 4 and 5, inorganic layer **606** is also suitably applied to metal layer **604** via CVD or PECVD deposition techniques.

With particular reference to FIG. 6a, respective photoresist structures **610, 612** may be printed onto metallic stack **602**, for example using, *inter alia*, any of the printing techniques discussed above. As can be seen in FIG. 6a, the side walls of photoresist structures **610, 612** exhibit a high degree of verticality, in part because of the anti reflective character of ARC layer **606**. To facilitate transfer of structures **610, 612** to metal stack **602**, the inorganic top layer **606** may suitably be planarized, using chemical mechanical polishing (cmp) prior to coating stack 602 with photoresist.

In order to transfer the photoresist pattern shown in FIG. 6a into the metal layer, the structure shown in FIG. 6a typically undergoes a metal etching process. In prior art systems utilizing an organic ARC layer, the organic ARC layer may be conveniently eroded in the presence of chlorine based etching environments or directional etching environments, i.e. where a bias is applied to the etching process, that are used in metal etching. In the context of the present invention, in contrast, inorganic layer **606** is desirably etched using a fluorine based etching solution including one or more of the following chemistries: CHF₃, C₂F₆, and CF₄ (tetrafluormethane).

With particular reference to FIG. 6b, inorganic layer **616** is suitably etched using an appropriate etching chemistry such as, for example, those described above.

Upon completion of the ARC layer etching step, the inorganic layer 606 is positioned between metal layer **604** and respective photoresist structures **610,612**. As seen in FIG. 6b, during this etching step, inorganic layer **606** is etched away, such as is indicated by arrow **618**. As shown in FIG. 6b, the interconnect substrate is prepared for metal etching (i.e., etching of metal layer **604** to transfer photoresist structure **610,612** into the metal).

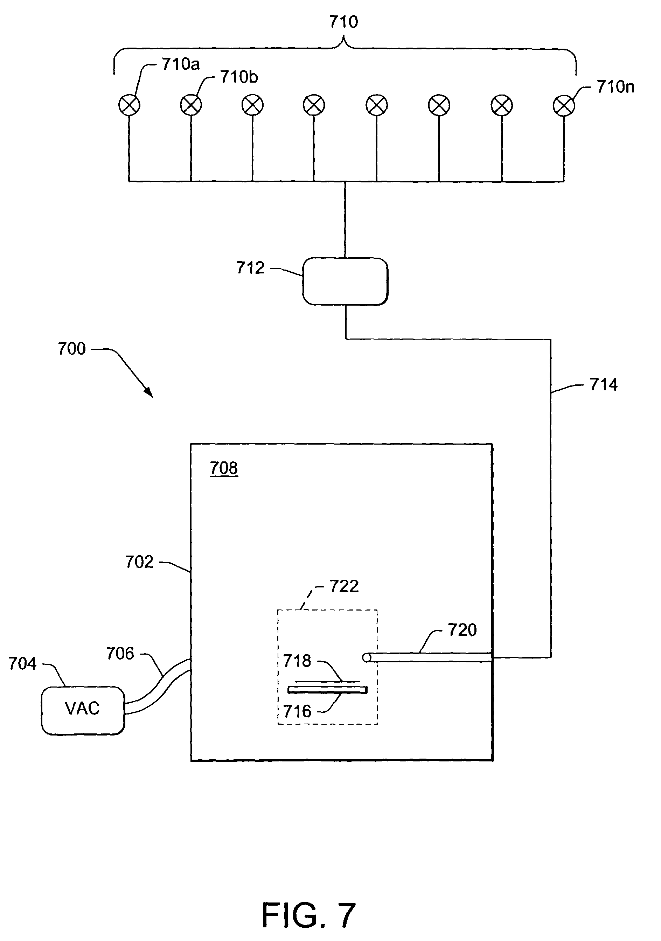

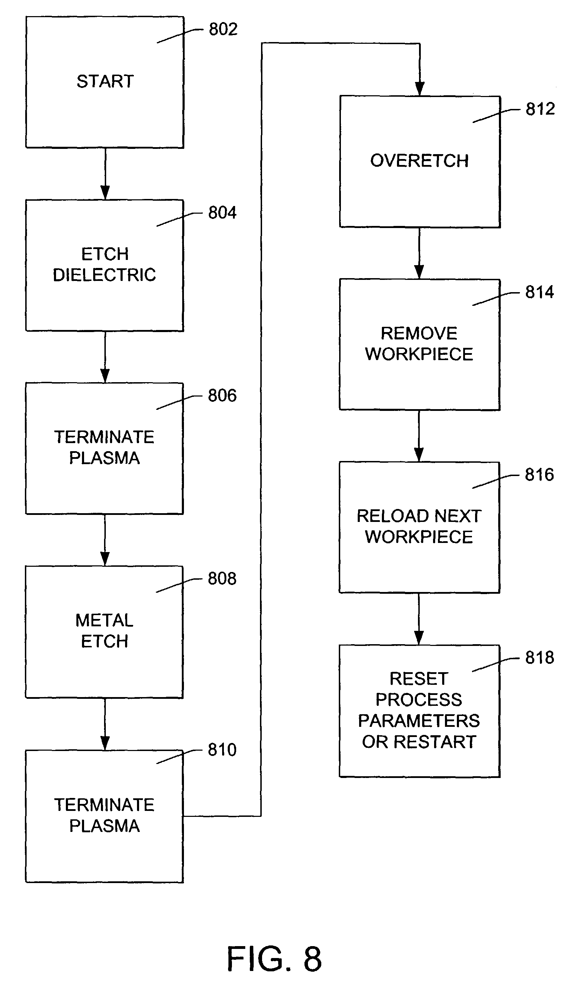

In accordance with a particularly preferred embodiment of the present invention, both the aforementioned inorganic etching step and the etching of metal layer **604** may advantageously be performed within the same tool, thus conserving processing steps and reducing the cost and complexity of producing the finished semiconductor interconnect structures. The details of this in-situ etching process are discussed in greater detail below in conjunction with FIG. 7 and 8.

With continued reference to FIG. 6, the substrate shown in FIG. 6b suitably undergoes metal etching, resulting in the structure shown in FIG. 6c.

With particular reference to FIG. 6c, photoresist structure **610** is suitably transferred into metal layer **604**, resulting in microelectronic structure **611**; similarly, photoresist structure **612** is transferred into the metal, resulting in microelectronic feature **613**.

More particularly, structure **611** suitably comprises a top portion **614**, a middle portion **622**, and a bottom portion **628**. In accordance with a preferred embodiment, top portion **614** suitably comprises that portion of inorganic layer **606** which was not etched away during the inorganic layer etching process. Middle portion **622** suitably comprises that portion of metal layer **604** which was not etched away during the metal etching step. Bottom portion **628** may comprise that portion of barrier layer **608** which was not etched during the aforementioned metal etching process; alternatively, bottom portion **628** may comprise part of barrier layer **608** and part of the bottom of metal layer **604** in the event metal layer **604** is incompletely etched. Depending on the level of the aggressiveness of the etching chemistry during the metal etch step, and further depending on such factors as the etch selectivity of the etch medium with regard to the photoresist and the metal layer **604**, some residual photoresist **632** may remain on the top of microelectronic structure **611** after the completion of the metal etching step. For smaller structures (e.g., deep sub-half-micron feature sizes), or in circumstances where a very thin photoresist layer is used or a very aggressive metal (and hence photoresist) etch solution is employed, it may be possible that all of the photoresist material on the surface of microelectronic structure **613** is partially or completely eroded during the metal etch process. By employing an inorganic ARC layer **606** which results in an inorganic ARC hard mask cap **616**, the structural integrity of the top portion **634** of microelectronic structure **613** is preserved; that is, even if the photoresist layer is completely eroded away, the metal etch chemistry does not dramatically effect the structure of microelectronic structure **613**, inasmuch as cap portion **616** is relatively impervious to the metal etch chemistry.

Referring now to FIG. 7, the etching of the inorganic layer, as well as subsequent etching of the metal layer described in connection with FIG. 6, is suitably performed within the same plasma enhanced etching chamber, resulting in substantial cost efficiencies inasmuch as both etching steps may be performed in-situ, that is, in the same tool.

With continued reference to FIG. 7, a suitable plasma etching assembly **700** preferably comprises an etching chamber **702**, a vacuum pump **704** connected to etching chamber **700** through a vacuum hose **706**, and a plurality of respective mask flow controllers (MFC) **710** which are suitably connected through a mixing valve or flow regulator **712** and a gas inlet conduit **714** to etching chamber **702.** In the interior region **708** of etching chamber **702**, a plasma zone **722** is suitably maintained. In a preferred embodiment, plasma etching chamber **702** may be obtained from Applied Materials, Inc. under the product designation decoupled plasma source or DPS.

Internal region **708** of metal etch chamber **702** suitably comprises a workpiece support **716**, for example an electrostatic chuck (ESC), configured to support a semiconductor interconnect substrate (such as shown in FIG. 6) **718** within the plasma region **722**. Those skilled in the art will appreciate that appropriate temperature control mechanisms may be incorporated into chuck **716** and/or into the side walls or other interior region of chamber **702** to control the temperature at the workpiece surface during the etching process. Moreover, those skilled in the art will further appreciate that an appropriate pressure may be maintained by vacuum pump **704** during the etching process. It is further understood that appropriate contamination control, ventilation, and other well known parameters may be accommodated by etching system **700**.

The various gasses used to effect the etching processes are conveniently applied into plasma region **722** through a gas inlet conduit **720** connected to external conduit **714**. In a preferred embodiment, the various MFC's **710**, control valve **712**, and the various other processing parameters are conveniently controlled through the use of a personal computer or other known control device.

With continued reference to FIG. 7 and referring also to FIG. 6 and 8, an in-situ ARC etching process and an in-situ metal etching process may suitably be performed in accordance with the following method:

When it is desired to etch the inorganic ARC layer **606** (see FIG. 6a), the substrate comprising metallic stack **602** and the photoresist structures formed thereon is suitably placed on chuck **716** (the interconnect workpiece modeled as workpiece **718** in FIG. 7). The various processing parameters appropriate for a particular etching recipe are then established (step **802**), including, *inter alia*, setting the proper temperature, pressure, plasma ignition times and dwell times, as well as selection of the appropriate mixture of gasses, gas rates and proportions to be fed to plasma region **722**. In a preferred embodiment, helium, nitrogen, or other appropriate medium may be employed to cool the surface of the workpiece via ESC **716**, as desired. Once the appropriate parameters are established, the dielectric layer is suitably etched (step **804**). In a preferred embodiment, the dielectric layer is suitably an inorganic film, for example, comprising silicon oxynitride, in which case fluorine based chemistries such as CHF₃, C₂F₆, and CF₄ may be employed. In accordance with an alternate embodiment, a metallic mask layer, such as tinitride, may be employed in lieu of the aforementioned inorganic hard mask layer. When an inorganic dielectric is employed, suitable etching chemistries include the aforementioned fluorine based chemistries, in combination with chlorine based chemistries such as BCL₃ (boron trichloride) and CL₂.

When inorganic layer **606** is substantially or completely etched (or the organic dielectric layer as discussed in the aforementioned offset embodiment), as shown in FIG. 6b, the plasma may be temporarily terminated to accommodate a reconfiguration of the gas mixture (step **806**); alternatively, the plasma may remain intact, and a gradual change in the gas composition may be affected to initiate the metal etch step.

The metal etching step (step **808**) suitably employs chlorine based chemistries such as BCL₃, CL₂, or other appropriate metal etching chemistries; as with the dielectric etch step described above in conjunction with step **804**, the metal etch process is also desirably conducted in the presence of an N₂ (nitrogen) or Ar (argon) gas mixture supplied to plasma chamber **722** from gas supply conduit **720**.

When the metal is substantially or completely etched to a desired level, the plasma may be extinguished (step **810**). Alternatively, the plasma may remain energized and the gas supplied to plasma chamber may be reformulated in the event it is desired to over etch the surface of the interconnect, for example to clear residuals.

If it is desired to over etch (step **812**), chlorine based chemistries such as BCL₃, CL₂, and the like may be employed with argon (Ar) either in addition to or in lieu of the nitrogen gas. In addition, in a preferred embodiment such over etching may be performed at a lower radiofrequency (RF) power, calculated to produce a lower energy plasma at the surface of workpiece **718**.

Once the metal etching process is complete (which may or may not include over etching, as desired), workpiece **718** may be removed (step **814**), whereupon another workpiece may be placed onto chuck **716** (step **816**). The process parameters for the new workpiece are then set (step **818**) if they are, different than the process parameters employed in conjunction with the previous etching recipes for the previous workpiece; otherwise, the process returns to step **804** for the next cycle of workpiece fabrication.

It should be understood that the foregoing description is of preferred exemplary embodiments of the invention and that the invention is not limited to the specific forms or structures shown or described herein. Various modifications may be made in the design, arrangement, and type of elements and structures disclosed herein, as well as the steps of making and using the invention without departing from the scope of the invention as expressed in the appended claims.

## Claims

1. A method of manufacturing a semiconductor device, comprising the steps of:
forming a metal stack (602) of a type which includes a metal layer (604) sandwiched between an upper inorganic anti - reflective coating (ARC) (606) layer and an oppositely disposed barrier layer (608);
coating said inorganic layer (606) with a photoresist layer,
exposing said photoresist layer through a patterned mask to yield a predetermined pattern of exposed regions in said photoresist layer;
developing said photoresist layer to print a photoresist pattern (610,612) on said inorganic layer (606);
etching (804) said inorganic layer (606), except in the region of said photoresist pattern, to at least partially expose said metal layer; and
thereafter etching (808) said metal layer except in the regions of said photoresist pattern (610,612).

2. The method of claim 1 wherein said step of forming a metal stack comprises the steps of:
placing said metal layer in a chemical vapor deposition (CVD) chamber; and
applying said inorganic layer to said metal layer by a CVD process.

3. The method of claim 2 wherein said applying step comprises generating a plasma to enhance said CVD process.

4. The method of any preceding claim, further comprising the step of planarizing said inorganic layer before coating said inorganic layer with said photoresist layer.

5. The method of claim 4 wherein said planarizing step comprises chemical mechanical planarization (CMP).

6. A substrate for use in forming a semiconductor interconnect structure, comprising:
a metal stack (402, 502)including a metal layer (404, 504) and an inorganic dielectric (406,512) film layer disposed on said metal layer (404, 504); and
a photoresist layer (410) disposed on said inorganic film layer (406,512).

7. The substrate of claim 6, wherein said metal layer (404, 504) comprises at least one of aluminium, titanium, copper, gold, silver, tungsten and nickel and/or combinations thereof.

8. The substrate of claim 6 or 7, wherein said metal layer (404, 504) has a thickness in the range of about 1,000 to 20,000 angstroms, said photoresist layer (410) has a thickness in the range of about 1,000 to 20,000 angstroms, and said inorganic film layer (406) has a thickness in the range of about 50 to 1000 angstroms.

9. The substrate of any one of claims 6 to 8, wherein said inorganic film layer (406) is an anti reflective coating.

10. The substrate of any one of claims 6 to 9, further comprising a second film layer (408) comprising a dielectric disposed on said metal layer opposite said inorganic film layer (406).

11. The substrate of any one of claims 6 to 10, wherein said metal layer (504) comprises sub-micron feature size microelectronic structures (506, 508, 510), and wherein said inorganic film layer (512) exhibits a generally uniform thickness which generally conforms to said metal layer, including said microelectronic structures (506, 508,510).

12. The substrate of any one of claims 6 to 11, wherein said inorganic film layer comprises silicon oxynitride.

13. A microelectronic interconnect structure having a substrate as claimed in any one of claims 6 to 12.

14. A microelectronic interconnect structure, comprising:
a plurality of microelectronic structures, at least one of said structures comprising:
i) a barrier layer (608) having a thickness less than 3,000 angstroms;
ii) a metal layer (604) having a thickness greater than about 1,000 angstroms disposed on said barrier layer (608); and
iii) an inorganic film layer (606) disposed on said metal layer (604) opposite said barrier layer (608).

15. The structure of claim 14, wherein said metal layer (604) comprises at least one of aluminium, tungsten, gold, or copper.

16. The structure of any one of claims 14 or 15, wherein said inorganic film layer is substantially uniform in thickness and has a thickness in the range of about 50 angstroms to about 1,000 angstroms.

17. The structure of any one of claims 14 to 16, wherein said inorganic film layer is a dielectric silicon composition, preferably silicon oxynitride.
